# FASCICULE DE BREVET EUROPEEN

(11) **EP 1 987 547 B1**
(45) Date de publication et mention de la délivrance du brevet: **15.07.2009**
(21) Numéro de dépôt: 07730945.8
(22) Date de dépôt: 08.02.2007
(51) Int. Cl.: H01L 31/042, H01L 31/048, H01L 31/0216, B61D 17/12

(54) **PANNEAU SOLAIRE SOUPLE NOTAMMENT POUR VEHICULE FERROVIAIRE**
BIEGSAMER SONNENKOLLEKTOR, IM BESONDEREN FÜR EIN SCHIENENFAHRZEUG
FLEXIBLE SOLAR PANEL, ESPECIALLY FOR A RAILWAY VEHICLE

(30) Priorité: 08.02.2006 FR 0601110
(43) Date de publication de la demande: 05.11.2008
(73) Titulaire: Société Nationale des Chemins de Fer Français, 75014 Paris (FR)
(72) Inventeur: GUENARD, Thierry, F-10100 Romilly sur Seine (FR); BONTEMS, Thomas, F-10120 Saint Andre les Vergers (FR)
(74) Mandataire: Bloch, Gérard
(86) Numéro de dépôt international: PCT/FR2007/000230
(87) Numéro de publication internationale: WO 2007/090966

(56) Documents cités:
- JP-A- 9 083 005
- US-A1- 2004 055 632
- US-B1- 6 608 464
- US-B1- 6 662 572

## Description

La présente invention concerne les panneaux solaires utilisés dans la transformation de l'énergie solaire en énergie électrique et destinés à être fixés sur des toitures de locaux à alimenter en énergie électrique. L'invention est née d'un problème de toitures de wagons de chemins de fer, mais cette application ne doit pas être considérée comme limitative.

Généralement, les wagons de chemin de fer, et plus généralement les véhicules ferroviaires, sont équipés d'accumulateurs embarqués, ce qui permet de disposer d'une source d'énergie et de leur éclairage lors des opérations de maintenance. Lors du roulage, les wagons sont alimentés par la motrice du train et les accumulateurs sont rechargés. Cependant, au garage, les accumulateurs se déchargent relativement vite, ce qui est préjudiciable à leur durée de vie et coûte cher. Le document US-B-6 662 572 décrit un panneau solaire comportant un film souple. Le document US-A-2004/055632 décrit des films auto-nettoyants pour panneaux solaires.

Il existe actuellement des wagons de voyageurs équipés de panneaux solaires capables de soulager la charge des accumulateurs, mais comme ces panneaux sont plans et rigides, alors que les toitures des wagons présentent une courbure importante, l'équipement de ces toitures n'est pas facile, sans parler des problèmes aérodynamiques et de gabarit. Cette solution ne peut notamment pas être envisagée pour des wagons circulant à grande vitesse.

C'est l'objet principal de la présente invention que de proposer un panneau solaire qui épouse au mieux le toit des véhicules et ne présente pas d'inconvénients aérodynamiques ou de gabarit. A nouveau, l'intention s'appliquera à tout véhicule ferroviaire (wagon, voiture, rame, locomotive, remorque, locotracteur, motrice, etc.) et, en pratique, à tout panneau solaire.

C'est un autre objet de la présente invention que de proposer un panneau solaire qui ne présente pas non plus d'inconvénients esthétiques.

C'est encore un autre objet de la présente invention que de proposer un panneau solaire dont la mise en oeuvre est peu coûteuse.

Pour cela, et sachant qu'il existe déjà sur le marché des films souples photovoltaïques de transformation d'énergie solaire en énergie électrique, l'invention concerne un panneau solaire, notamment pour véhicule ferroviaire, comportant un film souple photovoltaïque, d'un côté du film photovoltaïque, un film adhésif de fixation du film photovoltaïque au toit du véhicule, panneau caractérisé par le fait qu'il comporte, de l'autre côté du film photovoltaïque, un film auto-nettoyant et transparent aux rayons ultraviolet.

C'est donc un panneau solaire stratifié souple tri-couche adaptable à toute couverture présentant une surface de réception non plane, du type surface cylindrique ou ondulée, qui est proposé.

De préférence le film auto-nettoyant est également anti-graffiti.

Les films prenant le film photovoltaïque en sandwich peuvent être fixés à lui par une face adhésive, par thermocollage ou par des moyens analogues.

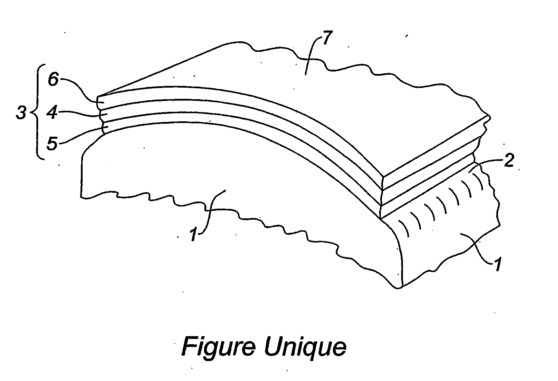

L'invention sera mieux comprise à la lecture de la description suivante faite en référence au dessin annexé représentant un panneau solaire conforme à l'invention mis en oeuvre sur le toit d'un wagon.

Soit un véhicule ferroviaire 1 qui comporte un toit 2 bombé de forme quasi-cylindrique. Un panneau solaire stratifié souple 3 recouvre le toit 2 et épouse sa forme.

Le panneau solaire 3 comporte un film souple photovoltaïque 4, en sandwich entre, ici, un film adhésif inférieur 5 de fixation du film photovoltaïque 4 fixant ce dernier au toit 2 du véhicule 1 et un film adhésif supérieur 6 transparent aux rayons ultraviolet de façon à permettre au film 4 de recevoir la lumière et de transmettre l'énergie solaire correspondante aux circuits d'alimentation (non représentés) du wagon 1.

Le film adhésif inférieur 5 est adhésif sur la face 8 destinée à adhérer au toit 2 du véhicule 1 et sur celle 9 sur laquelle est fixé le film photovoltaïque 4. On a donc ici recours à un film adhésif biface. Mais le film 5 peut aussi n'être adhésif que sur sa face inférieure, celle à fixer au toit 2, et le film photovoltaïque 4 être fixé au film 5 par tout autre moyen de fixation adéquat, par exemple par collage, en l'occurrence par thermocollage.

Ici, le film adhésif 6 présente une surface supérieure apparente 7 «auto - nettoyante» c'est-à-dire ne laissant pas ou peu de prises aux impuretés, autrement dit très lisse. Il est aussi « anti-graffiti », c'est-à-dire présentant une surface supérieure apparente 7 pouvant être facilement nettoyée. Ces types de surfaces sont utilisées couramment par les sociétés de chemins de fer pour protéger les véhicules des divagations picturales des adeptes de la petite dégradation.

Le film 6 est fixé au film photovoltaïque 4 par une face adhésive 10.

Le film photovoltaïque 4 peut avoir une épaisseur très faible, par exemple de deux ou trois millimètres à quelque dizaines de micronmètres, et le panneau souple 3, une épaisseur du même ordre de grandeur.

## Revendications

1. Panneau solaire, notamment pour véhicule ferroviaire (1), comportant un film souple photovoltaïque (4), d'un côté du film photovoltaïque, un film adhésif (5) de fixation du film photovoltaïque (4) au toit (2) du véhicule panneau **caractérisé par le fait qu'**il comporte, de l'autre côté du film photovoltaïque, un film (6) auto-nettoyant et transparent aux rayons ultraviolet.

2. Panneau solaire selon la revendication 1, dans lequel le film auto-nettoyant (6) est également anti-graffiti.

3. Panneau solaire selon l'une des revendications 1 et 2, dans lequel les films (5, 6) prenant le film photovoltaïque (4) en sandwich sont fixés à lui par une face adhésive (9, 10).

4. Panneau solaire selon l'une des revendications 1 et 2, dans lequel les films (5, 6) prenant le film photovoltaïque (4) en sandwich sont fixés à lui par thermocollage.

## Claims

1. Solar panel, in particular for a railway vehicle (1), comprising a flexible photovoltaic film (4), on one side of the photovoltaic film, an adhesive film (5) for fixing the photovoltaic film (4) to the roof (2) of the vehicle (1), said panel being **characterised in that** it comprises, on the other side of the photovoltaic film, a film (6) which is self-cleaning and transparent to ultraviolet rays.

2. Solar panel according to claim 1, in which the self-cleaning film (6) is likewise anti-graffiti.

3. Solar panel according to one of the claims 1 and 2, in which the films (5, 6) accepting the photovoltaic film (4) as a sandwich are fixed to the latter by an adhesive surface (9, 10).

4. Solar panel according to one of the claims 1 and 2, in which the films (5, 6) accepting the photovoltaic film (4) as a sandwich are fixed to the latter by thermal fusing.

## Patentansprüche

1. Solarkollektor, insbesondere für ein Schienenfahrzeug (1), mit einer biegsamen photovoltaischen Schicht (4), mit einer auf einer Seite der photovoltaischen Schicht angeordneten Klebeschicht (5) zur Befestigung der photovoltaischen Schicht (4) am Dach (2) des Fahrzeugs (1), wobei der Kollektor **dadurch gekennzeichnet ist, dass** er auf der anderen Seite der photovoltaischen Schicht eine selbstreinigende und für ultraviolette Strahlen transparente Schicht (6) aufweist.

2. Solarkollektor nach Anspruch 1, wobei die selbstreinigende Schicht (6) auch eine Anti-Graffiti-Schicht ist.

3. Solarkollektor nach einem der Ansprüche 1 und 2, wobei die Schichten (5, 6), zwischen denen die photovoltaische Schicht (4) angeordnet ist, an dieser mit einer Klebefläche (9, 10) befestigt sind.

4. Solarkollektor nach einem der Ansprüche 1 und 2, wobei die Schichten (5, 6), zwischen denen die photovoltaische Schicht (4) angeordnet ist, an dieser durch Heißkleben befestigt sind.
